# EUROPÄISCHE PATENTSCHRIFT

(11) **EP 1 025 470 B1**
(45) Veröffentlichungstag und Bekanntmachung des Hinweises auf die Patenterteilung: **03.07.2002**
(21) Anmeldenummer: 98962189.1
(22) Anmeldetag: 28.10.1998
(51) Int. Cl.: G05B 19/418

(54) **VERFAHREN ZUR ERMITTLUNG REALISIERBARER KONFIGURATIONEN VON BEARBEITUNGSANLAGEN**
PROCESS FOR DETERMINING POSSIBLE CONFIGURATIONS OF MACHINING PLANTS
PROCEDE POUR DETERMINER LES CONFIGURATIONS REALISABLES D'INSTALLATIONS D'USINAGE

(30) Priorität: 28.10.1997 DE 19747574
(43) Veröffentlichungstag der Anmeldung: 09.08.2000
(73) Patentinhaber: Infineon Technologies AG, 81669 München (DE)
(72) Erfinder: BUCHSCHMID, Hans, D-93164 Laaber (DE); KANNE, Stefan, D-93049 Regensburg (DE); FEDERL, Peter, D-93080 Pentling (DE); SCHEBESTA, Michael, D-81737 München (DE); HIRTREITER, Peter, D-93098 Mintraching (DE); BREHM, Klaus, D-93170 Bernhardswald (DE); BRANDT, Jürgen, D-92421 Schwandorf (DE)
(74) Vertreter: Kindermann, Peter, Dipl.-Ing.
(86) Internationale Anmeldenummer: DE9803159
(87) Internationale Veröffentlichungsnummer: WO9922279

(56) Entgegenhaltungen:
- US-A- 5 105 362
- US-A- 5 195 041
- US-A- 5 402 350
- US-A- 5 444 632

## Beschreibung

Die vorliegende Erfindung betrifft Verfahren zur Steuerung einer Vielzahl von Bearbeitungsanlagen, welche jeweils mehrere Bearbeitungsmodule aufweisen, zur Produktion zumindest eines Produkts.

Moderne industrielle Produktion ist im allgemeinen durch einen hohen Grad der Automatisierung gekennzeichnet. Insbesondere in der Halbleiterindustrie ist ein hoher Automatisierungsgrad unabdingbar, um international wettbewerbsfähig sein zu können.

Während der Herstellung durchlaufen die Produkte eine Reihe von Bearbeitungsschritten, die automatisiert von unterschiedlichen Bearbeitungsanlagen an dem zu bearbeitenden Produkt vorgenommen werden. Beispielsweise durchläuft bei der Produktion eines integrierten Halbleiterprodukts das Produkt bis zu 600 Prozeßschritte, die zu einem großen Teil nur mit hoch spezialisierten Bearbeitungsanlagen in einer Reinraumumgebung durchgeführt werden können. Dabei sind häufig mehrere gleichartige Bearbeitungsanlagen zu einem Bearbeitungsbereich ("Bay") zusammengefaßt.

Die zur Bearbeitung von Produkten verwandten Bearbeitungsanlagen können Einzelmodule sein, mit denen zu jedem Zeitpunkt nur ein einziger Bearbeitungsschritt ausgeführt werden kann. Diese Einzelmodule können dann unabhängig voneinander gesteuert werden können, wie beispielsweise in US 5 444 632 beschrieben.

Moderne Bearbeitungsanlagen hingegen sind sog. "Cluster Tools" , d.h. sie besitzen üblicherweise mehrere Module, welche die eigentliche Bearbeitung des zu bearbeitenden Produkts übernehmen. Dabei können die Module so ausgewählt sein, daß die Module nur jeweils unterschiedliche Bearbeitungsschritte ausführen können.

Das zu bearbeitende Produkt muß dann zumindest einen Teil der Module in einer vorgegebenen Reihenfolge durchlaufen, um die durch die jeweilige Bearbeitungsanlage vorgesehene Bearbeitung zu erfahren. Die Module einer Bearbeitungsanlage können aber auch so ausgewählt sein, daß zumindest ein Teil der Module die jeweils gleichen Bearbeitungsschritte durchführen kann. Dies hat den Vorteil, daß beim Ausfall eines Moduls dieses Modul durch ein entsprechendes Modul ersetzt werden kann, ohne daß die gesamte Bearbeitungsanlage ausfällt. Durch den modularen Aufbau der Bearbeitungsanlage ist es ohne großen Aufwand möglich, mehrere unterschiedliche Produkte durch eine Bearbeitungsanlage zu bearbeiten. Dies erhöht die Flexibilität und damit die Rentabilität der Produktion.

Die Kosten für eine derartige automatisierte Produktion werden zu einem goßen Teil von der Frage beeinflußt, wie gut und effizient der Herstellungsprozeß gesteuert und geplant werden kann. Zur Steuerung des gesamten Herstellungsprozesses eines bestimmten Produkts wird zuerst ein Arbeitsplan für das jeweilige Produkt erstellt. In dem Arbeitsplan werden eine Vielzahl von Prozeßzielen definiert, wobei die einzelnen Prozeßziele durch eine oder mehrere Einzelprozeßanweisungen (EPA) konkretisiert werden. Eine Einzelprozeßanweisung benennt üblicherweise die Bearbeitungsanlage, auf der die Bearbeitung des Produkts erfolgen soll, und sie enthält darüber hinaus das genau Arbeitsprogramm (z.B. ein "NC-Programm"), das von der Bearbeitungsanlage abgearbeitet werden soll. Der Arbeitsplan besteht somit aus einer langen Reihe von Einzelprozeßanweisungen, durch die die Bearbeitung des jeweiligen Produkts festgelegt ist.

Sollen nun innerhalb einer vorgegebenen Zeitdauer ein Produkt oder mehrere unterschiedliche Produkte in großer Stückzahl produziert werden, so ergibt sich die Frage, in welcher Reihenfolge die einzelnen Einzelprozeßanweisungen von den Bearbeitungsanlagen abgearbeitet werden sollen (Produktionssteuerung). Dies wird noch durch die Tatsache erschwert, daß nicht immer alle vorhandenen Bearbeitungsanlagen zur Verfügung stehen. Durch Wartungs- bzw. Reparaturarbeiten kann häufig ein der Teil der Bearbeitungsanlagen nicht oder nur eingeschränkt verwendet werden, was natürlich bei der Produktionssteuerung bzw. bei der Produktionsplanung berücksichtigt werden muß.

Leider schenken die bisher verwendeten Verfahren zur Produktionssteuerung der Tatsache, daß durch Wartungs- bzw. Reparaturarbeiten häufig ein Teil der Bearbeitungsanlagen nicht oder nur eingeschränkt verwendet werden kann, nur wenig Beachtung, so daß es häufig zu einer fehlerhaften Produktionssteuerung bzw. fehlerhaften Aussagen hinsichtlich der Auslastung der Bearbeitungsanlagen und/oder hinsichtlich der Durchlaufzeiten der unterschiedlichen Produkte kommt.

Es ist daher die Aufgabe der vorliegenden Erfindung, Verfahren zur Ermittlung realisierbarer Konfigurationen von Bearbeitungsanlagen für die Produktionssteuerung und/oder Produktionsplanung bereitzustellen, die die genannten Nachteile der bisherigen Verfahren vermeiden oder mindern.

Diese Aufgabe wird durch die Verfahren nach den Patentansprüchen 1 und 3 gelöst.

Erfindungsgemäß werden zwei Verfahren zur Steuerung einer Vielzahl von Bearbeitungsanlagen, welche jeweils mehrere Bearbeitungsmodule aufweisen, bereitgestellt. Die erfindungsgemäßen Verfahren enthalten gemeinsam die folgenden Schritte:
- zu dem Produkt wird eine Folge von Einzelprozeßanweisungen ermittelt, durch welche jeweils eine bestimmte Bearbeitungsanlage ausgewählt wird und die von der Bearbeitungsanlage abzuarbeitenden Bearbeitungsschritte definiert werden,
- entsprechend den abzuarbeitenden Bearbeitungsschritten werden mögliche Konfigurationen der Bearbeitungsanlage und die mit den einzelnen Konfigurationen verbundenen Zeitdauern der Bearbeitung des Produkts in der Bearbeitunganlage ermittelt,
- Informationen zu dem Zustand der Bearbeitungsmodule in den Bearbeitungsanlagen werden ermittelt,
- aus den Informationen zu dem Zustand der Bearbeitungsmodule und den gemäß den abzuarbeitenden Bearbeitungsschritten möglichen Konfigurationen der Bearbeitungsanlage werden die gemäß dem Zustand der Bearbeitungsmodule realisierbaren Konfigurationen der Bearbeitungsanlage und die mit den einzelnen Konfigurationen verbundenen Zeitdauern der Bearbeitung des Produkts in der Bearbeitungan lage ermittelt,
- auf der Grundlage der realisierbaren Konfigurationen und der mit den einzelnen Konfigurationen verbundenen Zeitdauern wird in einem Optimierungsalgorithmus eine Reihenfolge der abzuarbeitenden Einzelprozeßanweisungen in den einzelnen Bearbeitungsanlagen festgelegt.

Diese Schrittfolge ermöglicht es, daß die unterschiedlichen Bearbeitungszeiten, welche sich durch den Ausfall/Sperrung eines oder mehrerer Bearbeitungsmodule in einer Bearbeitungsanlage für eine bestimmte Einzelprozeßanweisung ergeben, in der Produktionssteuerung bzw. Produktionsplanung berücksichtigt werden. Dementsprechend führt die Produktionssteuerung zu einer effizienteren sowie kostengünstigeren Produktion.

Die so gewonnenen realisierbaren Konfigurationen der Bearbeitungsanlage und die mit den einzelnen Konfigurationen verbundenen Zeitdauern der Bearbeitung des Produkts in der Bearbeitungsanlage sind nun die Grundlage für Optimierungsalgorithmen um eine möglichst effizient Reihenfolge der abzuarbeitenden Einzelprozeßanweisungen an den einzelnen Bearbeitungsanlagen festzulegen (Produktionssteuerung).

In dem Verfahren nach Anspruch 1 werden erfindungsgemäß Informationen darüber ermittelt, welche Einzelprozeßanweisungen gleichzeitig von einer Bearbeitungsanlage ausgeführt werden können. Bei der Abarbeitung einer Einzelprozeßanweisung auf einer Bearbeitungsanlage kann die Situation auftreten, daß nicht alle Bearbeitungsmodule der Bearbeitungsanlage für die Abarbeitung dieser Einzelprozeßanweisung benötigt werden. Daher könnten die nicht benötigten Bearbeitungsmodule zur Abarbeitung weiterer Einzelprozeßanweisungen genutzt werden.

Die kombinierbaren, d.h. gleichzeitig auf einer Bearbeitungsanlage ausführbaren Einzelprozeßanweisungen werden vorzugsweise explizit als solche gekennzeichnet.

Für die Produktion des Produkts wird ein Arbeitsplan erstellt, der den Herstellungsprozeß des Produkts in einzelne Prozeßziele gliedert, wobei die einzelnen Prozeßziele häufig durch eine oder auch mehrere Einzelprozeßanweisungen realisiert werden können. In dem Verfahren nach Anspruch 3 wird der Herstellungsprozeß des Produkts in einzelne Prozeßziele gegliedert, die durch eine oder mehrere Einzelprozeßanweisungen realisiert werden, und es werden erfindungsgemäß solche Prozeßziele vorgesehen, die entweder durch eine oder mehrere Einzelprozeßanweisungen, durch welche eine Bearbeitungsanlage ausgewählt wird, oder durch mehrere Einzelprozeßanweisungen, durch welche zumindest zwei unterschiedliche Bearbeitungsanlagen ausgewählt werden, realisierbar sind.

Üblicherweise sind die Bearbeitungsanlagen und die Prozeßziele so aufeinander abgestimmt, daß das Ergebnis einer Bearbeitungsanlage einem Prozeßziel entspricht. Somit wird das Prozeßziel durch eine oder mehrere Einzelprozeßanweisungen realisiert, durch welche jeweils nur eine entsprechende Bearbeitungsanlage ausgewählt wird. Kommt es zum Ausfall von einzelnen Bearbeitungsmodulen in einer Bearbeitungsanlage, so können manche Prozeßziele auf dieser Bearbeitungsanlage nicht mehr erreicht werden, da für diese Prozeßziele notwendige Bearbeitungsschritte nur von den ausgefallenen Bearbeitungsmodulen abgearbeitet werden können. Sind jedoch noch weitere Bearbeitungsanlagen vorhanden, deren Bearbeitungsmodule gerade diese Bearbeitungsschritte übernehmen könnten, so ist das erfindungsgemäße Verfahren in der Lage, das Prozeßziel durch eine oder mehrere neue Einzelprozeßanweisungen zu realisieren, durch welche nun der Teil des Prozeßziels, der die ausgefallenen Bearbeitungsmodule betrifft, auf einer zusätzlichen Bearbeitungsanlage durchgeführt werden kann. Auf diese Weise können die nicht ausgefallenen Bearbeitungsmodule einer Bearbeitungsanlage weiter zur Realisierung des Prozeßziels verwendet werden. In vielen Fällen kann dadurch die durch den Ausfall der Bearbeitungsmodule bedingte Erhöhung der Durchlaufzeit deutlich verringert werden.

Bei der Abarbeitung der Bearbeitungsschritte durch die Bearbeitungsmodule kann der Fall auftreten, daß ein erster Bearbeitungsschritt einen zweiten Bearbeitungsschritt negativ beeinflußt, obwohl die beiden Bearbeitungsschritte in unterschiedlichen Bearbeitungsmodulen durchgeführt werden. Beispielsweise können Materialien, die für den ersten Bearbeitungsschritt benötigt werden, zu Kontaminationen in dem zweiten Bearbeitungsschritt führen. Bei einer bevorzugten Ausführungsform des erfindungsgemäßen Verfahren werden derartige Abhängigkeiten daher berücksichtigt, so daß sich die vorhandene Bearbeitungskapazität effizienter nutzen läßt.

Weiterhin ist es bevorzugt, wenn die Zeitdauer, in der ein Bearbeitungsmodul nicht benutzt wird, festgehalten wird, wobei zwischen einem Ausfall des Bearbeitungsmoduls aufgrund von technischen Ursachen und einer Nichtbenutzung des Bearbeitungsmoduls aufgrund der gerade in der Bearbeitungsanlage abgearbeitenden Einzelprozeßanweisungen unterschieden wird. Dies erlaubt die Analyse von Auslastungsverlusten, was bisher in keinem Verfahren zur Produktionssteuerung bzw. zur Produktionsplanung durchgeführt werden konnte.

Die Erfindung wird nachfolgend anhand von Figuren der Zeichnung näher dargestellt. Es zeigen:
Fig. 1 eine schematische Darstellung einer Bearbeitungsanlage, ein sogenanntes "Cluster Tool", wie sie in der Halbleitertechnik verwendet wird,
Fig. 2 eine schematische Darstellung eines Bearbeitungsbereichs, der zwei Bearbeitungsanlagen umfaßt.

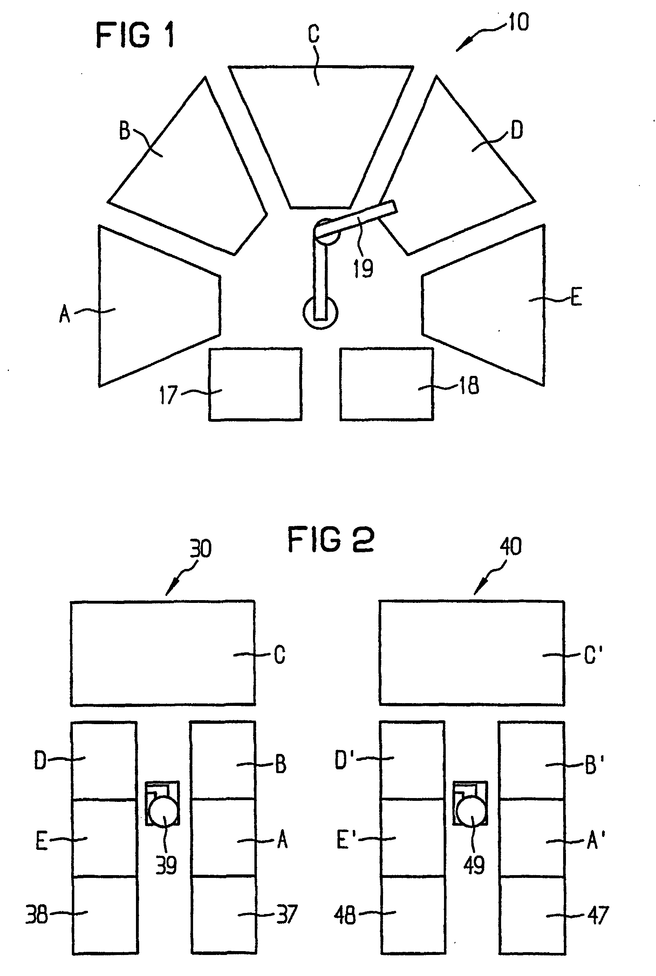

Fig. 1 zeigt eine schematische Darstellung einer Bearbeitungsanlage, ein sogenanntes "Cluster Tool", wie sie in der Halbleitertechnik verwendet wird. Die Bearbeitungsanlage 10 besitzt fünf Bearbeitungsmodule A, B, C, D und E, sogenannte Prozeßkammern, in den beispielsweise CVD-Verfahren (chemical vapor deposition) zur Schichterzeugung auf einem Halbleitersubstrat durchgeführt werden können. Darüberhinaus besitzt die Bearbeitungsanlage 10 zwei Be- und Entladestationen 17 und 18, durch welche Halbleiterwafer zur Bearbeitung in die Bearbeitungsanlage 10 eingeführt und nach der Bearbeitung aus der Bearbeitungsanlage 10 heraus geführt werden können. Der Transport der Halbleiterwafer innerhalb der Bearbeitungsanlage 10 wird durch einen Roboterarm 19 durchgeführt, der im Zentrum der Bearbeitungsanlage 10 angeordnet ist.

Die folgende Liste zeigt einen möglichen Aufbau einer Einzelprozeßanweisung (EPA) für die Durchführung des erfindungsgemäßen Verfahrens.

| | |
|---|---|
| Nummer der EPA | 101 |
| Nummer der Bearbeitungsanlage | 10 |
| abzuarbeitendes Programm | Sequence 1 |
| Standardzeit | 33 min |
| Bearbeitungsmodule | A, B, C, D, E |
| Konfiguration | 1, 2, 1, 2, 0 |

Die Einzelprozeßanweisung benennt die Bearbeitungsanlage auf der bestimmte Bearbeitungsschritte ("abzuarbeitendes Programm") durchgeführt werden sollen. Weiterhin macht die Einzelprozeßanweisung eine Aussage darüber, wie lange die Bearbeitungsanlage zur Abarbeitung dieser Bearbeitungsschritte braucht, wenn alle notwendigen Bearbeitungmodule A, B, C, D (in diesem Beispiel, da Modul E nicht benötigt wird) sowie der Roboterarm 19 und die Be- und Entladestationen voll funktionfähig sind. Weiterhin benennt die Einzelprozeßanweisung die Bearbeitungsmodule der ausgewählten Bearbeitungsanlage und schließlich werden mögliche Konfigurationen der Bearbeitungsmodule für die Abarbeitung der Bearbeitungsschritte bereitgestellt.

Die Ziffer "0" bei dem Bearbeitungsmodul E gibt an, das dieses Bearbeitungsmodul bei der vorliegenden Einzelprozeßanweisung nicht benötigt wird. Die Ziffer "1" bei den Bearbeitungsmodulen A und C gibt an, daß für die vorliegende Einzelprozeßanweisung diese Bearbeitungsmodule als gleichwertig angesehen werden. Das heißt, daß die von dem Bearbeitungsmodul A durchzuführenden Bearbeitungsschritte auch vom Bearbeitungsmodul C (und umgekehrt) durchgeführt werden können. Entsprechend gibt die Ziffer "2" bei den Bearbeitungsmodulen B und D an, daß für die vorliegende Einzelprozeßanweisung diese Bearbeitungsmodule als gleichwertig angesehen werden. Hingegen können Bearbeitungsmodule, die mit der Ziffer "1" versehen sind, nicht die Aufgaben der Bearbeitungsmodule, die mit der Ziffer "2" versehen sind. Bearbeitungsmodule mit einer gemeinsamen Ziffer bildet somt eine Gruppe, wobei von jeder Gruppe mindestens ein Bearbeitungsmodul verfügbar sein muß, um die Einzelprozeßanweisung ausführen zu können.

Daraus folgt, daß bei dem vorliegenden Beispiel folgende Konfigurationen (K 1 - K 9) der Bearbeitungsanlage eingesetzt werden können:

**Tabelle 1**

| | K 1 | K 2 | K 3 | K 4 | K 5 | K 6 | K 7 | K 8 | K 9 |
|---|---|---|---|---|---|---|---|---|---|
| Modul A | + | + | + | + | - | - | - | + | + |
| Modul B | + | + | - | + | + | - | + | - | + |
| Modul C | + | - | - | - | + | + | + | + | + |
| Modul D | + | + | + | - | + | + | - | + | - |
| Modul E | - | - | - | - | - | - | - | - | - |

Das Zeichen "+" bedeutet dabei, daß das jeweilige Bearbeitungsmodul für die Abarbeitung der Einzelprozeßanweisung verwendet wird. Das Zeichen "-" bedeutet, daß das jeweilige Bearbeitungsmodul für die Abarbeitung der Einzelprozeßanweisung nicht verwendet wird oder werden kann (technische Downtime oder Sperrung für den Prozeß).

Weiterhin werden bei dem erfindungsgemäßen Verfahren die mit den einzelnen Konfigurationen (K 1 - K 9) verbundenen Zeitdauern der Bearbeitung des Produkts in der Bearbeitunganlage bereitgestellt. Dies ergibt sich beispielsweise aus der folgenden Tabelle:

**Tabelle 2**

| | K 1 | K 2 | K 3 | K 4 | K 5 | K 6 | K 7 | K 8 | K 9 |
|---|---|---|---|---|---|---|---|---|---|
| Zeit/min | 33 | 50 | 59 | 59 | 50 | 59 | 59 | 44 | 44 |

Anstatt der absoluten Zeiten könnten aber auch Verlängerungsfaktoren gegenüber der Standardzeit von 33 min bereitgestellt werden. Die den einzelnen Konfigurationen zugeordneten Zeitdauern können bei Probeläufen der Bearbeitungsanlage experimentell oder durch eine Simulation der Bearbeitungsanlage rechnerisch gewonnen werden.

Zusätzlich zu den für eine Einzelprozeßanweisung möglichen Konfigurationen der Bearbeitungsmodule werden bei dem erfindungsgemäßen Verfahren Informationen zu dem Zustand der Bearbeitungsmodule in den Bearbeitungsanlagen bereitgestellt. In der Regel liegen vielfältige Informationen über den Zustand der Bearbeitungsmodule vor. Dabei ist wichtig , daß aus diesen Zustandsinformation abgeleitet werden kann, ob ein Bearbeitungsmodul verfügbar ist. Dabei können die Informationen zu dem Zustand der Bearbeitungsmodule den momentanen, realen Zustand der Bearbeitungsmodule oder einen statistisch gemittelten Zustand der Bearbeitungsmodule repräsentieren.

Die folgende Tabelle zeigt ein Beispiel für Zustandsinformationen zu den Bearbeitungsmodulen:

**Tabelle 3**

| | Modul A | Modul B | Modul C | Modul D | Modul E |
|---|---|---|---|---|---|
| Zustand | UP | UP | UP | DOWN | UP |

Das Zeichen "UP" bedeutet dabei, daß das jeweilige Bearbeitungsmodul für die Abarbeitung der Einzelprozeßanweisung verfügbar ist. Das Zeichen "DOWN" bedeutet, daß das jeweilige Bearbeitungsmodul für die Abarbeitung der Einzelprozeßanweisung aus technischen Gründen (Wartung, Reparatur, ...) oder aus Prozeßgründen (Partikel, unstabile Prozesse, ...) nicht verfügbar ist.

Aus diesen Informationen zu dem Zustand der Bearbeitungsmodule werden die gemäß dem Zustand der Bearbeitungsmodule realisierbaren Konfigurationen der Bearbeitungsanlage ermittelt. Im vorliegenden Beispiel sind folgende Konfigurationen der Bearbeitungsanlage realisierbar:

**Tabelle 4**

| realisierbar | K 4 | K 7 | K 9 |
|---|---|---|---|
| Zeit/min | 59 | 59 | 44 |

Die Tabelle 4 enthält auch die mit den einzelnen, realisierbaren Konfigurationen verbundenen Zeitdauern der Bearbeitung des Produkts in der Bearbeitungsanlage.

Die so gewonnenen realisierbaren Konfigurationen der Bearbeitungsanlage und die mit den einzelnen Konfigurationen verbundenen Zeitdauern der Bearbeitung des Produkts in der Bearbeitungsanlage sind die Grundlage für Optimierungsalgorithmen um eine möglichst effiziente Reihenfolge der abzuarbeitenden Einzelprozeßanweisungen an den einzelnen Bearbeitungsanlagen festzulegen (Produktionssteuerung).

Die so gewonnenen realisierbaren Konfigurationen der Bearbeitungsanlage und die mit den einzelnen Konfigurationen verbundenen Zeitdauern der Bearbeitung des Produkts in der Bearbeitungsanlage können aber auch dazu benutzt werden, um bei einer vorgegebenen Reihenfolge der abzuarbeitenden Einzelprozeßanweisungen an den einzelnen Bearbeitungsanlagen Durchlaufzeiten für einzelne Produkte sowie Produktionskapazitäten zu bestimmen (Produktionsplanung).

Weiterhin wird die Zeitdauer, in der ein Bearbeitungsmodul nicht benutzt wird, festgehalten, wobei zwischen einem Ausfall des Bearbeitungsmoduls aufgrund von technischen Ursachen und einer Nichtbenutzung des Bearbeitungsmoduls aufgrund der gerade in der Bearbeitungsanlage abgearbeiteten Einzelprozeßanweisung unterschieden wird. Im vorliegende Beispiel werden die Bearbeitungsmodule D und E nicht verwendet. Dies hat jedoch unterschiedliche Ursachen. Bearbeitungsmodul D wird nicht benutzt, da es, beispielsweise bedingt durch eine Reparatur, überhaupt nicht zur Verfügung steht. Bearbeitungsmodul E wird nicht benutzt, da es, obwohl es verfügbar wäre, für die vorliegende Einzelprozeßanweisung nicht gebraucht wird. Diese Informationen können nun zu einer Analyse von Auslastungsverlusten für die Produktionsplanung führen. Auf diese Weise läßt sich beispielsweise feststellen, daß für die vorgesehenen Produkte die Bearbeitungsanlage 10 ein fünftes Bearbeitungsmodul E nicht benötigt, so daß das Bearbeitungsmodul E aus der Bearbeitungsanlage 10 ausgebaut und in eine andere Bearbeitungsanlage, in der es häufiger gebraucht wird, eingebaut werden könnte.

Im folgenden wird die parallele Durchführung von zwei unterschiedlichen Einzelprozeßanweisungen auf einer Bearbeitungsanlage betrachtet.

Dabei enthält die erste Einzelprozeßanweisung (EPA 1) folgende Daten:

| | |
|---|---|
| Nummer der EPA | 105 |
| Nummer der Bearbeitungsanlage | 10 |
| abzuarbeitendes Programm | Sequence 3 |
| Standardzeit | 40 min |
| Bearbeitungsmodule | A, B, C, D, E |
| Konfiguration | 1, 2, 2, 0, 0 |

Die zweite Einzelprozeßanweisung (EPA 2) ist durch folgende Daten festgelegt:

| | |
|---|---|
| Nummer der EPA | 110 |
| Nummer der Bearbeitungsanlage | 10 |
| abzuarbeitendes Programm | Sequence 6 |
| Standardzeit | 45 min |
| Bearbeitungsmodule | A, B, C, D, E |
| Konfiguration | 0, 0, 1, 2, 2 |

Weiterhin werden bei dieser Ausführungsform des erfindungsgemäßen Verfahrens Informationen darüber bereitgestellt, welche Einzelprozeßanweisungen gleichzeitig von einer Bearbeitungsanlage ausgeführt werden können. Bei dem vorliegende Beispiel können EPA 1 und EPA 2 prinzipiell gemeinsam auf der Bearbeitungsanlage 10 ausgeführt werden. Da bei dem erfindungsgemäßen Verfahren Informationen zu dem Zustand der Bearbeitungsmodule in den Bearbeitungsanlagen bereitgestellt werden, ist möglich zu entscheiden, ob die beiden Einzelprozeßanweisungen auch tatsächlich gleichzeitig ausgeführt werden können.

Legt man wiederum die genannten Zustandsinformationen zu den Bearbeitungsmodulen

**Tabelle 5**

| | Modul A | Modul B | Modul C | Modul D | Modul E |
|---|---|---|---|---|---|
| Zustand | UP | UP | UP | DOWN | UP |

zu Grunde, so erhält man folgende Konfiguration der Bearbeitungsanlage für die gemeinsame Abarbeitung der beiden Einzelprozeßanweisungen:

**Tabelle 6**

| | EPA 1 | EPA 2 |
|---|---|---|
| Modul A | + | - |
| Modul B | + | - |
| Modul C | - | + |
| Modul D | - | - |
| Modul E E | - | + |
| Zeit/min | 40 | 45 |

Durch das erfindungsgemäße Verfahren wird die gemeinsame Ausführung mehrerer Einzelprozeßanweisungen auf einer Bearbeitungsanlage somit besser steuerbar bzw. besser planbar.

Gemäß einer bevorzugten Ausführungsform des erfindungsgemäßen Verfahrens wird für die Produktion eines Produkts ein Arbeitsplan erstellt, der den Herstellungsprozeß des Produkts in einzelne Prozeßziele gliedert, wobei die einzelnen Prozeßziele durch eine oder mehrere Einzelprozeßanweisungen realisiert werden. Dabei ist es insbesondere bevorzugt, wenn Prozeßziele vorgesehen sind, die sowohl durch eine oder mehrere Einzelprozeßanweisungen, durch welche eine Bearbeitungsanlage ausgewählt wird, als auch durch mehrere Einzelprozeßanweisungen, durch welche zumindest zwei unterschiedliche Bearbeitungsanlagen ausgewählt werden, realisiert werden können. Dies soll im folgenden anhand von Fig. 2 erläutert werden.

Bei der Produktion von integrierten Halbleiterprodukten werden zur Strukturierung des Halbleitersubstrats in der Regel Lackmasken auf dem Halbleitersubstrat verwendet. Der Arbeitsplan für die Produktion eines integrierten Halbleiterprodukts enthält daher auch das Prozeßziel "Erzeugung einer Lackmaske". Im Normalfall ist dafür jeweils eine Bearbeitungsanlage innerhalb eines Bearbeitungsbereichs vorgesehen.

Fig. 2 zeigt eine schematische Darstellung eines Bearbeitungsbereichs ("Bay"), der zwei Bearbeitungsanlagen 30 und 40 zur Erzeugung von Lackmasken auf einem Halbleitersubstrat umfaßt.

Die Bearbeitungsanlagen 30 und 40 besitzen ebenfalls jeweils fünf Bearbeitungsmodule A, B, C, D und E bzw. A', B', C', D' und E', wobei die Module A und B bzw. A' und B' der Belackung des Halbleitersubstrats, die Module C bzw. C' der Belichtung und die Module D und E bzw. D' und E' der Entwicklung des belichteten Lacks dienen. Darüberhinaus besitzen die Bearbeitungsanlagen 30 und 40 jeweils zwei Be- und Entladestationen 37 und 38 bzw 47 und 48, durch welche Halbleiterwafer zur Bearbeitung in die Bearbeitungsanlagen 30 und 40 eingeführt und nach der Bearbeitung aus den Bearbeitungsanlagen 30 und 40 heraus geführt werden können. Der Transport der Halbleiterwafer innerhalb der Bearbeitungsanlagen 30 und 40 wird jeweils durch einen Roboterarm 39 bzw 49 durchgeführt.

Zu Realisierung des Prozeßziels "Erzeugung einer Lackmaske" in der Bearbeitungsanlage 30 kann nun folgende Einzelprozeßanweisung verwendet werden.

Erzeugung einer Lackmaske:

| | |
|---|---|
| Nummer der EPA | 130 |
| Nummer der Bearbeitungsanlage | 30 |
| abzuarbeitendes Programm | Sequence 1 |
| Standardzeit | 240 min |
| Bearbeitungsmodule | A, B, C, D, E |
| Konfiguration | 1, 1, 2, 3, 3 |

Sind jedoch die Bearbeitungsmodule A und B wartungsbedingt nicht verfügbar, so kann die Einzelprozeßanweisung nicht ausgeführt werden bzw. die gesamte Bearbeitungsanlage 30 kann nicht benutzt werden.

Gemäß dem erfindungsgemäßen Verfahren wird daher das Prozeßziel Erzeugung einer Lackmaske" durch zwei Einzelprozeßanweisungen realisiert, wobei die eine Einzelprozeßanweisung die Bearbeitungsanlage 40 und die andere Einzelprozeßanweisung die Bearbeitungsanlage 30 benennt.

Belackung:

| | |
|---|---|
| Nummer der EPA | 121 |
| Nummer der Bearbeitungsanlage | 40 |
| abzuarbeitendes Programm | Sequence 12 ("Belackung") |
| Standardzeit | 40 min |
| Bearbeitungsmodule | A', B', C', D', E' |
| Konfiguration | 1, 1, 0, 0, 0 |

Belichtung und Entwicklung:

| | |
|---|---|
| Nummer der EPA | 122 |
| Nummer der Bearbeitungsanlage | 30 |
| abzuarbeitendes Programm | Sequence 13 ("Belichtung und Entwicklung") |
| Standardzeit | 200 min |
| Bearbeitungsmodule | A, B, C, D, E |
| Konfiguration | 0, 0, 1, 2, 2 |

Die Einzelprozeßanweisung "Belackung" kann nun gleichzeitig mit der üblichen Einzelprozeßanweisung "Erzeugung einer Lackmaske" auf der Bearbeitungsanlage 40 abgearbeitet werden. Durch das erfindungsgemäße Verfahren ist es somit auf einfache Weise möglich, Bearbeitungsmodule aus einer Bearbeitungsanlage einer anderen Bearbeitungsanlage zur Weiterbearbeitung zur Verfügung zu stellen und die sich daraus ergebenden Auswirkungen auf den Gesamtprozeß zu berücksichtigen.

## Patentansprüche

1. Verfahren zur Steuerung einer Vielzahl von Bearbeitungsanlagen, welche jeweils mehrere Bearbeitungsmodule aufweisen, zur Produktion zumindest eines Produkts, mit den Schritten:
- zu dem Produkt wird eine Folge von Einzelprozeßanweisungen ermittelt, durch welche jeweils eine bestimmte Bearbeitungsanlage ausgewählt wird und die von der Bearbeitungsanlage abzuarbeitenden Bearbeitungsschritte definiert werden,
- entsprechend den abzuarbeitenden Bearbeitungsschritten werden mögliche Konfigurationen der Bearbeitungsanlage und die mit den einzelnen Konfigurationen verbundenen Zeitdauern der Bearbeitung des Produkts in der Bearbeitunganlage ermittelt,
- Informationen zu dem momentanen, realen Zustand der Bearbeitungsmodule in den Bearbeitungsanlagen werden ermittelt,
- aus den Informationen zu dem Zustand der Bearbeitungsmodule und den gemäß den abzuarbeitenden Bearbeitungsschritten möglichen Konfigurationen der Bearbeitungsanlage werden die gemäß dem Zustand der Bearbeitungsmodule realisierbaren Konfigurationen der Bearbeitungsanlage und die mit den einzelnen Konfigurationen verbundenen Zeitdauern der Bearbeitung des Produkts in der Bearbeitunganlage ermittelt,
- auf der Grundlage der realisierbaren Konfigurationen und der mit den einzelnen Konfigurationen verbundenen Zeitdauern wird in einem Optimierungsalgorithmus eine Reihenfolge der abzuarbeitenden Einzelprozeßanweisungen in den einzelnen Bearbeitungsanlagen festgelegt,
wobei Informationen darüber ermittelt werden, welche Einzelprozeßanweisungen gleichzeitig von einer Bearbeitungsanlage ausgeführt werden können.

2. Verfahren nach Anspruch 1,
**dadurch gekennzeichnet,**
**daß** kombinierbare Einzelprozeßanweisungen explizit als solche **gekennzeichnet** werden.

3. Verfahren zur Steuerung einer Vielzahl von Bearbeitungsanlagen, welche jeweils mehrere Bearbeitungsmodule aufweisen, zur Produktion zumindest eines Produkts, mit den Schritten:
- zu dem Produkt wird eine Folge von Einzelprozeßanweisungen ermittelt, durch welche jeweils eine bestimmte Bearbeitungsanlage ausgewählt wird und die von der Bearbeitungsanlage abzuarbeitenden Bearbeitungsschritte definiert werden,
- entsprechend den abzuarbeitenden Bearbeitungsschritten werden mögliche Konfigurationen der Bearbeitungsanlage und die mit den einzelnen Konfigurationen verbundenen Zeitdauern der Bearbeitung des Produkts in der Bearbeitunganlage ermittelt,
- Informationen zu dem momentanen, realen Zustand der Bearbeitungsmodule in den Bearbeitungsanlagen werden ermittelt,
- aus den Informationen zu dem Zustand der Bearbeitungsmodule und den gemäß den abzuarbeitenden Bearbeitungsschritten möglichen Konfigurationen der Bearbeitungsanlage werden die gemäß dem Zustand der Bearbeitungsmodule realisierbaren Konfigurationen der Bearbeitungsanlage und die mit den einzelnen Konfigurationen verbundenen Zeitdauern der Bearbeitung des Produkts in der Bearbeitunganlage ermittelt,
- auf der Grundlage der realisierbaren Konfigurationen und der mit den einzelnen Konfigurationen verbundenen Zeitdauern wird in einem Optimierungsalgorithmus eine Reihenfolge der abzuarbeitenden Einzelprozeßanweisungen in den einzelnen Bearbeitungsanlagen festgelegt,
wobei der Herstellungsprozeß des Produkts in einzelne Prozeßziele gegliedert wird, die durch eine oder mehrere Einzelprozeßanweisungen realisiert werden,
und wobei solche Prozeßziele vorgesehen werden, die entweder durch eine oder mehrere Einzelprozeßanweisungen, durch welche eine Bearbeitungsanlage ausgewählt wird, oder durch mehrere Einzelprozeßanweisungen, durch welche zumindest zwei unterschiedliche Bearbeitungsanlagen ausgewählt werden, realisierbar sind.

4. Verfahren nach einem der Ansprüche 1 bis 3,
**dadurch gekennzeichnet,**
**daß** berücksichtigt wird, daß ein erster Bearbeitungsschritt einen zweiten negativ beeinflussen kann, auch wenn der erste und der zweite Bearbeitungsschritt in unterschiedlichen Bearbeitungsmodulen durchgeführt werden.

5. Verfahren nach einem der Ansprüche 1 bis 4,
**dadurch gekennzeichnet,**
**daß** die Zeitdauer, in der ein Bearbeitungsmodul nicht benutzt wird, festgehalten wird, wobei zwischen einem Ausfall des Bearbeitungsmoduls aufgrund von technischen Ursachen und einer Nichtbenutzung des Bearbeitungsmoduls aufgrund der gerade in der Bearbeitungsanlage abgearbeitenden Einzelprozeßanweisung unterschieden wird.

## Claims

1. Processes for controlling a large number of machining plants which each have a number of machining modules, for the production of at least one product, comprising the steps:
- of determining for the product a sequence of individual process instructions by which in each case a particular machining plant is selected and the machining steps to be executed by the machining plant are defined,
- of determining according to the machining steps to be executed possible configurations of the machining plant and the time periods associated with the individual configurations for machining the product in the machining plant,
- of determining information on the actual state at a given moment of the machining modules in the machining plants,
- of determining from the information on the state of the machining modules and the possible configurations of the machining plant according to the machining steps to be executed the configurations of the machining plant that are feasible according to the state of the machining modules and the time periods associated with the individual configurations for machining the product in the machining plant,
- of defining in an optimizing algorithm on the basis of the feasible configurations and the time periods associated with the individual configurations a sequence of the individual process instructions to be executed in the individual machining plants,
information being determined as to which individual process instructions can be executed simultaneously by a machining plant.

2. Processes according to Claim 1, **characterized in that** individual process instructions that can be combined are explicitly identified as such.

3. Processes for controlling a large number of machining plants which each have a number of machining modules, for the production of at least one product, comprising the steps:
- of determining for the product a sequence of individual process instructions by which in each case a particular machining plant is selected and the machining steps to be executed by the machining plant are defined,
- of determining according to the machining steps to be executed possible configurations of the machining plant and the time periods associated with the individual configurations for machining the product in the machining plant,
- of determining information on the actual state at a given moment of the machining modules in the machining plants,
- of determining from the information on the state of the machining modules and the possible configurations of the machining plant according to the machining steps to be executed the configurations of the machining plant that are feasible according to the state of the machining modules and the time periods associated with the individual configurations for machining the product in the machining plant,
- of defining in an optimizing algorithm on the basis of the feasible configurations and the time periods associated with the individual configurations a sequence of the individual process instructions to be executed in the individual machining plants,
the manufacturing process of the product being divided into individual process objectives which are realized by one or more individual process instructions,
and those process objectives being provided which can be realized either by one or more individual process instructions by which a machining plant is selected or by a number of individual process instructions by which at least two different machining plants are selected.

4. Processes according to one of Claims 1 to 3, **characterized in that** account is taken of the fact that a first machining step may have an adverse influence on a second machining step, even if the first and second machining steps are executed in different machining modules.

5. Processes according to one of Claims 1 to 4, **characterized in that** the time period in which a machining module is not being used is recorded, a distinction being drawn between failure of the machining module on account of technical causes and non-use of the machining module on account of the individual process instruction being executed at the time in the machining plant.

## Revendications

1. Procédé destiné à la commande d'un grand nombre d'installations d'usinage, qui comportent chacune plusieurs modules d'usinage, pour la production d'au moins un produit, et comportant les étapes suivantes :
- on détermine pour le produit une succession d'instructions individuelles de processus par lesquelles est sélectionnée respectivement une installation d'usinage déterminée et sont définies les étapes d'usinage devant être traitées par l'installation d'usinage,
- conformément aux étapes d'usinage devant être traitées, on détermine des configurations possibles de l'installation d'usinage et les durées de l'usinage du produit dans l'installation d'usinage, liées aux configurations individuelles,
- on détermine des informations relatives à l'état réel momentané, des modules d'usinage dans les installations d'usinage,
- à partir des informations relatives à l'état des modules d'usinage et des configurations de l'installation d'usinage possibles conformément aux étapes d'usinage à traiter, on détermine les configurations de l'installation d'usinage pouvant être réalisées conformément à l'état des modules d'usinage, et les durées de l'usinage du produit dans l'installation d'usinage, liées aux configurations individuelles,
- sur la base des configurations réalisables et des durées liées aux configurations individuelles, on définit dans un algorithme d'optimisation, une succession ordonnée des instructions individuelles de processus à traiter dans les installations d'usinage individuelles,
des informations étant déterminées quant aux instructions individuelles de processus pouvant être exécutées simultanément par une installation d'usinage.

2. Procédé selon la revendication 1, **caractérisé en ce que** des instructions individuelles de processus pouvant être combinées sont **caractérisées** explicitement en tant que telles.

3. Procédé destiné à la commande d'un grand nombre d'installations d'usinage, qui comportent chacune plusieurs modules d'usinage, pour la production d'au moins un produit, et comportant les étapes suivantes :
- on détermine pour le produit une succession d'instructions individuelles de processus par lesquelles est sélectionnée respectivement une installation d'usinage déterminée et sont définies les étapes d'usinage devant être traitées par l'installation d'usinage,
- conformément aux étapes d'usinage devant être traitées, on détermine des configurations possibles de l'installation d'usinage et les durées de l'usinage du produit dans l'installation d'usinage, liées aux configurations individuelles,
- on détermine des informations relatives à l'état réel momentané, des modules d'usinage dans les installations d'usinage,
- à partir des informations relatives à l'état des modules d'usinage et des configurations de l'installation d'usinage possibles conformément aux étapes d'usinage à traiter, on détermine les configurations de l'installation d'usinage pouvant être réalisées conformément à l'état des modules d'usinage, et les durées de l'usinage du produit dans l'installation d'usinage, liées aux configurations individuelles,
- sur la base des configurations réalisables et des durées liées aux configurations individuelles, on définit dans un algorithme d'optimisation, une succession ordonnée des instructions individuelles de processus à traiter dans les installations d'usinage individuelles,
le processus de fabrication du produit étant divisé en objectifs de processus individuels, qui sont réalisés par une ou plusieurs instructions individuelles de processus,
et l'on prévoit des objectifs de processus tels, qu'ils puissent être réalisés soit par une ou plusieurs instructions individuelles de processus par lesquelles une installation d'usinage est sélectionnée, soit par plusieurs instructions individuelles de processus par lesquelles au moins deux installations d'usinage différentes sont sélectionnées.

4. Procédé selon l'une des revendications 1 à 3, **caractérisé en ce que** l'on tient compte du fait qu'une première étape d'usinage peut en influencer une seconde de manière négative, même lorsque la première et la seconde étape d'usinage sont effectuées dans des modules d'usinage différents.

5. Procédé selon l'une des revendications 1 à 4, **caractérisé en ce que** l'on retient la durée pendant laquelle un module d'usinage n'est pas utilisé, en faisant la distinction entre une défaillance du module d'usinage en raison de causes techniques, et une non utilisation du module d'usinage en raison de l'instruction individuelle de processus traitée actuellement dans l'installation d'usinage.
